(19) Europäisches Patentamt
European Patent Office
Office européen des brevets

(11) **EP 2 884 233 B1**

(12) **EUROPÄISCHE PATENTSCHRIFT**

(45) Veröffentlichungstag und Bekanntmachung des Hinweises auf die Patenterteilung:
**01.09.2021 Patentblatt 2021/35**

(21) Anmeldenummer: **14197061.6**

(22) Anmeldetag: **09.12.2014**

(51) Int Cl.:
*H01H 47/04* (2006.01)  *H01H 47/02* (2006.01)
*G01K 7/16* (2006.01)  *G01D 3/02* (2006.01)
*G01D 5/20* (2006.01)  *G01R 31/327* (2006.01)
*H01F 7/18* (2006.01)  *H01H 47/00* (2006.01)
*H01H 71/04* (2006.01)

(54) **Messgrößenerfassung im elektromagnetischen Antrieb eines Schaltgeräts**

Measuring of parameters in an electromagnetic drive of a switching device

Mesure de paramètres dans un entraînement électromagnétique d'un appareil de commutation

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **16.12.2013  DE 102013114076**

(43) Veröffentlichungstag der Anmeldung:
**17.06.2015  Patentblatt 2015/25**

(73) Patentinhaber: **Eaton Intelligent Power Limited Dublin 4 (IE)**

(72) Erfinder: **Schaar, Ingo**
**53123 Bonn (DE)**

(74) Vertreter: **Eaton IP Group**
**EMEA**
**c/o Eaton Industries Manufacturing GmbH**
**Route de la Longeraie 7**
**1110 Morges (CH)**

(56) Entgegenhaltungen:
EP-A1- 0 549 911    DE-A1-102007 063 479
FR-A1- 2 803 956    US-A- 3 337 777

**Beschreibung**

Die Erfindung betrifft eine Vorrichtung zur Messgrössenerfassung im elektromagnetischen Antrieb eines Schaltgeräts, insbesondere eines Schützes, eine Steuer- und eine Regelvorrichtung mit einer derartigen Messgrössenerfassungsvorrichtung und Schaltgeräte mit einer derartigen Steuer- bzw. Regelvorrichtung.

Aus der deutschen Patentanmeldung DE 10 2012 106 922.0 ist eine Regelung des elektromagnetischen Antriebs eines Schaltgeräts bekannt, bei dem sowohl eine Anzug- als auch eine Haltespule eingesetzt wird. Die Haltespule wird hierbei während des Anzugvorgangs als Messspule für die Regelung eingesetzt. Bei einem solchen Schaltantrieb sind für die Haltespule auf der Platine mit der Steuerelektronik des Schaltgeräts zusätzliche Kontakte für die Anzugspule erforderlich, was zu einem erhöhten Produktionsaufwand in der Produktion von Schaltgeräten führt und zudem eine zusätzliche Fehlerquelle darstellt.

Die europäische Patentanmeldung EP0549911A1 beschreibt eine Vorrichtung zur Überwachung der Induktivität einer Spule, welche nicht Teil einer Resonanzschaltung ist, mit einer zweiten Spule, die in Reihe zur Spule geschaltet ist, und einem Schwingkreis, der durch die Verbindung eines Kondensators mit der zweiten Spule oder optional mit einer dritten Spule, die in einer gegenseitig induktiven Beziehung mit der zweiten Spule steht, ausgebildet ist, so dass die zweite und dritte Spule als Primär- und Sekundärspulen eines Transformators wirken. Vorgesehen sind weiterhin Mittel zur Injektion eines Wechselstromsignals in die Schaltung mit der ersten und zweiten Spule mit einer im Wesentlichen konstanten Spitzenspannungsamplitude mit einer Frequenz innerhalb der Resonanzspitze des Schwingkreises und ein Amplitudendetektor zum Messen der Amplitude der Spannung an eine Komponente des Schwingkreises. Die Vorrichtung kann als sogenannte integrale Steuerung im geschlossenen Regelkreis der Lagerung eines Objektes mit der ersten Spule verwendet werden. Das Ausgangssignal des Amplitudendetektors kann in einer solchen Anordnung erforderlich sukzessive einem Fehlerdetektor und einem Integrator zugeführt werden. Allerdings treten bei dieser Schaltung im Betrieb prinzipbedingt aufgrund des Schwingkreises Resonanzen auf, die eventuell zu höheren Belastungen der Bauteile führen und die Elektromagnetische Verträglichkeit (EMV) beeinflussende Störfrequenzen verursachen können. Zudem werden spezielle Baugruppen wie Frequenzgeneratoren und Resonanzbausteine benötigt. was die Implementierung dieser Schaltung aufwendig gestaltet.

Die DE102007063479 beschreibt ein Verfahren zur Erzeugung eines Signals, das anzeigt, dass ein Anker eines Elektromagneten eine Endlage erreicht hat, wobei bei dem Verfahren ein durch den Elektromagneten fließender Strom fortlaufend gemessen wird. Die Messwerte des Stroms werden daraufhin überwacht, ob nach einer Zeitspanne, in der die Stromstärke kleiner geworden ist, die Stromstärke wieder größer wird. Bei Auftreten einer solchen Vergrößerung der Stromstärke wir das Signal ausgegeben.

Die FR2803956 zeigt einen Leistungsschalter mit einem Gleichstromwandler zwischen einer Gleichstromversorgung und einer Schaltspule. Der Wandler wird kontrolliert in Abhängigkeit von der Differenz des von der Spule durchflossenen Stroms und dem zum Schließen oder Halten des Schalters benötigten Stroms. Der Strom wird gesteuert in einer Folge von Schalt- und Haltestrom.

Die US333777 zeigt ein Schaltgerät, das einen Schaltvorgang durchführt, sobald die Frequenz der anliegenden Spannung einen Schwellwert unterschreitet, um gestörte Betriebszustände zu detektieren, wie zum Beispiel eine Überlast.

Aufgabe der vorliegenden Erfindung ist es nun, ein Schaltgerät mit einer Vorrichtung zur Messgrössenerfassung im elektromagnetischen Antrieb vorzuschlagen, die prinzipiell auch mit einspuligen elektromagnetischen Antrieben eingesetzt werden kann und mit einer im Vergleich zu dem aus der europäischen Patentanmeldung EP0549911A1 bekannten Stand der Technik technisch weniger aufwendigen Schaltung implementiert werden kann.

Diese Aufgabe wird durch die Gegenstände der unabhängigen Ansprüche gelöst. Weitere Ausgestaltungen der Erfindung sind Gegenstand der abhängigen Ansprüche.

Ein der vorliegenden Erfindung zugrunde liegender Gedanke besteht darin, in Reihe zu einer Spule eines elektronmagnetischen Antriebs eines Schaltgeräts einen induktiven Übertrager zu schalten, und über diesen Übertrager Messgrößen des elektromagnetischen Antriebs ohne einen aufwendigen Schwingkreis wie bei der aus der europäischen Patentanmeldung EP0549911A1 bekannten Vorrichtung direkt an der Sekundärseite des Übertragers mit einer digitalen elektronischen Messvorrichtung zu erfassen, die insbesondere keine zusätzlichen Bauteile wie Frequenzgeneratoren oder Resonanzbauelemente benötigt, so dass im Betrieb die EMV weniger beeinflusst wird. Insbesondere kann die digitale elektronische Messvorrichtung durch einen mittels einer entsprechenden Firmware für die Messaufgaben konfigurierten Mikroprozessor oder Mikrokontroller implementiert werden, bedarfsweise zusammen mit einer vorgeschalteten Signalverarbeitung in Form einer Impedanzanpassung bzw. einer Offsetgenerierung. Der induktive Übertrager ist hierbei derart bemessen, dass er den Antrieb möglichst wenig beeinflusst. Ein solcher Übertrager kann auch in einem elektromagnetischen Antrieb eingesetzt werden, der nur eine Spule aufweist. Grundsätzlich ist er aber mit nahezu jeder Art von elektromagnetischem Schaltgeräte-Antrieb nutzbar, also auch mit Antrieben mit getrennter Halte- und Anzugspule. Die Messgrössenerfassungsvorrichtung kann ohne zusätzliche Kontakte auf der Platine mit der Steuerelektronik des Schaltgeräts implementiert werden, insbesondere indem der Übertrager direkt in den Leistungskreis eines elektromagnetischen Antriebs integriert wird. Dadurch können der Produktionsaufwand und die Anzahl der Fehlerquellen reduziert werden.

Die Erfindung betrifft nun ein Schaltgerät, insbesondere ein Schütz, mit einem elektromagnetischen Schaltantrieb, der ein Antriebsspulensystem, insbesondere mit einer Anzugspule und einer Haltespule, aufweist, und einer Steuer- oder Regelvorrichtung zum Steuern der Bestromung des Antriebsspulensystems oder zum Regeln des elektromagnetischen Antriebs, wobei die Steuer- oder Regelvorrichtung eine Vorrichtung zur Messgrössenerfassung im elektromagnetischen Antrieb des Schaltgeräts aufweist, mit einem induktiven Übertrager, dessen Primärseite in Reihe mit einer Spule des elektromagnetischen Antriebs geschaltet ist, und einer mit der Sekundärseite des Übertragers verbundenen digitalen elektronischen Messvorrichtung zum Messen einer auf die Sekundärseite übertragenen Spannung $U_{L2}$ und zum Ermitteln von mindestens einer Messgröße des elektromagnetischen Antriebs abhängig von der gemessenen Spannung $U_{L2}$ und bekannten Werten des Übertragers und / oder des Antriebs gemäß mindestens einer Ermittlungs- und Berechnungsfunktion.

Die Messvorrichtung kann konfiguriert sein, um einen durch die Spule des elektromagnetischen Antriebs fließenden Strom i gemäß der Gleichung

$$i = \frac{N_1}{L_1 \cdot N_2} \cdot \int U_{L2} \cdot dt$$

zu ermitteln, wobei $L_1$ die Induktivität und $N_1$ die Windungszahl der Primärseite und $L_2$ die Induktivität und $N_2$ die Windungszahl der Sekundärseite des Übertragers bezeichnen.

Insbesondere kann die Messvorrichtung konfiguriert sein, den Verlauf des Stromes i zu ermitteln und abhängig vom ermittelten Verlauf eine Einbaulage des Schaltgeräts zu ermitteln. Beispielsweise kann die Messvorrichtung die Montage- oder Einbaulage eines Schaltgeräts dadurch ermitteln, dass sie den Zeitpunkt ermittelt, in dem die Spannung $U_{L2}$ etwa Null ist, da dann der elektromagnetische Antrieb in Bewegung ist und der für die Bewegung verantwortliche Strom seinen vorläufigen maximalen Punkt erreicht, der von der Einbau- oder Montagelage des Antriebs abhängig ist.

Weiterhin kann die Messvorrichtung konfiguriert sein, den Strom i zu ermitteln, wenn der elektromagnetische Antrieb in einem Haltezustand betrieben wird, in dem sich der Antrieb nicht in Bewegung befindet, und abhängig vom ermittelten Strom die Temperatur des Spule des elektromagnetischen Antriebs zu ermitteln.

Die Messvorrichtung kann auch konfiguriert sein, um einen Anker-Kern-Stoß durch Auswerten des Verlaufs der gemessenen Spannung $U_{L2}$ zu ermitteln, indem ein Anker-Kern-Stoß detektiert wird, wenn die Spannung $U_{L2}$ einen Sprung vom negativen in den positiven Bereich macht.

Die Messvorrichtung kann auch konfiguriert sein, den Zeitpunkt des Auftretens eines Anker-Kern-Stosses zu ermitteln und abhängig von dem ermittelten Zeitpunkt einen Zustand der Mechanik des elektromagnetischen Antriebs zu ermitteln. Der ermittelte Zustand kann von der Messvorrichtung beispielsweise über eine Schnittstelle ausgegeben werden. Wird beispielsweise der Anker-Kern-Stoß zu einem sehr frühen Zeitpunkt nach Bestromung des Antriebs erkannt, kann davon ausgegangen werden, dass die Abdruckkräfte von Federn des Antriebs, beispielsweise bei einen Bruch einer Feder, zu gering ist. Wird dagegen der Anker-Kern-Stoß zu einem relativ späten Zeitpunkt detektiert, kann beispielsweise von einem erhöhten Reibungswiderstand der Mechanik des Antriebs ausgegangen werden.

Die digitale elektronische Messvorrichtung kann insbesondere konfiguriert sein, eine Zeitmessfunktion zu implementieren, um den Zeitpunkt eines Anker-Kern-Stosses nach Bestromung des Antriebs zu ermitteln und zu überprüfen, ob der ermittelte Zeitpunkt in einem vorgegebenen Bereich liegt, der einen vorgegebenen, insbesondere guten Zustand der Antriebsmechanik umfasst. Dadurch kann durch die Messvorrichtung bestimmt werden, ob die Mechanik des elektromagnetischen Antriebs noch den Anforderungen entspricht, die durch den vorgegebenen Zeitbereich definiert sind.

Weiterhin kann die Messvorrichtung konfiguriert sein, um die Induktivität $L_{Antrieb}$ der Spule des elektromagnetischen Antriebs gemäß der Gleichung

$$L_{Antrieb} = (\frac{U_{PWM}}{U_{L2} \cdot \beta} - 1) \cdot L_1$$

zu ermitteln, wobei $L_1$ die Induktivität der Primärseite des Übertragers und $\beta$ den Faktor der Übertragung der Spannung $U_{L1}$ an der Primärseite des Übertragers auf die Spannung $U_{L2}$ bezeichnen, und wobei $U_{PWM}$ die über der Reihenschaltung der Spule (14) des elektromagnetischen Antriebs und der Primärseite (12) des Übertragers (10) abfallende und von der Messvorrichtung (18) ermittelte Spannung bezeichnet. Insbesondere kann die Messvorrichtung konfiguriert sein, um anhand einer Kennlinie s(L$_{Antrieb}$) der Induktivität der Spule des elektromagnetischen Antriebs einen Luftspalt im elektromagnetischen Antrieb zu bestimmen.

Schließlich kann die Messvorrichtung auch konfiguriert sein, um den magnetischen Verkettungsfluss $\Psi_{Antrieb}$ im elektromagnetischen Antrieb abhängig von der ermittelten Induktivität L$_{Antrieb}$ der Spule des elektromagnetischen Antriebs und dem ermittelten durch die Spule des elektromagnetischen Antriebs fließenden Anzugstrom i gemäß der Gleichung

$$\Psi_{Antrieb} = L_{Antrieb} \cdot i$$

zu ermitteln.

Eine weitere Ausführungsform der Erfindung betrifft ein Schaltgerät, insbesondere ein Schütz, mit einer Vorrichtung zum Steuern des elektromagnetischen Antriebs des Schaltgeräts, der ein Antriebsspulensystem, insbesondere mit einer Anzugspule und einer Haltespule, aufweist, mit einer Messgrössenerfassungsvorrichtung, die konfiguriert ist, um einen Anker-Kern-Stoß durch Auswerten des Verlaufs der gemessenen Spannung U$_{L2}$ zu ermitteln, indem ein Anker-Kern-Stoß detektiert wird, wenn die Spannung U$_{L2}$ einen Sprung vom negativen in den positiven Bereich macht, und mit einer Ansteuerelektronik zum Steuern des elektromagnetischen Antriebs, die derart konfiguriert ist, dass sie bei Detektion eines Anker-Kern-Stoßes eine Bestromung des Antriebsspulensystems von einem Anzug- auf einen Haltebetrieb umschaltet, insbesondere die Bestromung der Anzugspule abschaltet und eine Bestromung der Haltespule einschaltet.

Eine weitere Ausführungsform der Erfindung betrifft ein Schaltgerät, insbesondere ein Schütz, mit einer Messgrössenerfassungsvorrichtung, die wie oben beschrieben zum Ermitteln der Induktivität L$_{Antrieb}$ der Spule des elektromagnetischen Antriebs, des Luftspalts im elektromagnetischen Antrieb und/oder des magnetischen Verkettungsflusses $\Psi_{Antrieb}$ im elektromagnetischen Antrieb konfiguriert ist, und mit einer Vorrichtung, zum Beispiel einer Ansteuerelektronik, zum Regeln des elektromagnetischen Antriebs, die derart konfiguriert ist, dass sie die Bestromung einer Spule des elektromagnetischen Antriebs abhängig von der ermittelten Induktivität L$_{Antrieb}$, vom ermittelten Luftspalt und/oder vom ermittelten magnetischen Verkettungsfluss Antrieb regelt.

Weitere Vorteile und Anwendungsmöglichkeiten der vorliegenden Erfindung ergeben sich aus der nachfolgenden Beschreibung in Verbindung mit den in den Zeichnungen dargestellten Ausführungsbeispielen.

In der Beschreibung, in den Ansprüchen, in der Zusammenfassung und in den Zeichnungen werden die in der hinten angeführten Liste der Bezugszeichen verwendeten Begriffe und zugeordneten Bezugszeichen verwendet.

Die Zeichnungen zeigen in

Fig. 1 ein Schaltbild eines Ausführungsbeispiels einer Vorrichtung zur Messgrössenerfassung im elektromagnetischen Antrieb eines Schaltgeräts gemäß der Erfindung;

Fig. 2 ein Diagramm mit beispielhaften Verläufen von einer mit der erfindungsgemäßen Vorrichtung erfassten Spannung U$_{L2}$ und eines von der erfindungsgemäßen Vorrichtung ermittelten durch die Spule des elektromagnetischen Antriebs fließenden Anzugstroms i;

Fig. 3 ein Diagramm mit dem Verlauf der mit der erfindungsgemäßen Vorrichtung erfassten Spannung U$_{L2}$; und

Fig. 4 ein Diagramm mit Verläufen des Antriebsströme in einem Schützantrieb bei unterschiedlicher Montage des Schützes und dem Verlauf der mit der erfindungsgemäßen Vorrichtung erfassten Spannung U$_{L2}$.

In der folgenden Beschreibung können gleiche, funktional gleiche und funktional zusammenhängende Elemente mit den gleichen Bezugszeichen versehen sein. Absolute Werte sind im Folgenden nur beispielhaft angegeben und sind nicht als die Erfindung einschränkend zu verstehen.

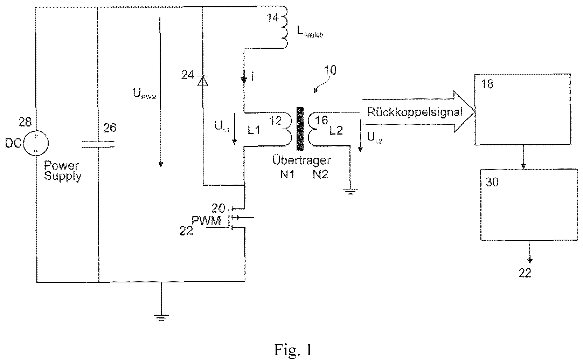

In Fig. 1 ist die Ansteuerung einer Antriebsspule 14 mit der Induktivität L$_{Antrieb}$ eines elektromagnetischen Antriebs eines Schaltgeräts und die Integration einer Vorrichtung zur Messgrössenerfassung gemäß der Erfindung gezeigt. Die Primärseite 12, d.h. die primärseitige Spule mit der Induktivität L$_1$ und Windungszahl N$_1$, eines Übertragers 10 ist in Reihe zur Antriebsspule 14 geschaltet. Weiterhin ist zu den beiden Spulen 12 und 14 die Laststrecke eines Feldeffekttransistors (FET) 20 in Reihe geschaltet.

Die Reihenschaltung aus den beiden Spulen 12 und 14 und der Laststrecke des FET 20 wird von einer Gleichspannungsquelle 28 mit Gleichstrom versorgt. Parallel zur Gleichspannungsquelle 28 ist ein Kondensator 26 zur Pufferung geschaltet. Eine Freilaufdiode 24 verbindet die Anschlüsse der Reihenschaltung der Spule 12 und 14, so dass beim Abschalten der an den Spulen 12 und 14 anliegenden Spannung ein induzierter Strom über die Freilaufdiode 24 fließen kann.

Im Folgenden wird kurz der Betrieb der Ansteuerung des elektromagnetischen Antriebs zum Verständnis beschrieben: um Schaltkontakte des Schaltgeräts zu schließen, muss die Antriebsspule 14 bestromt werden. Während des Anzugvorgangs ist zum Schließen der Schaltkontakte eine höhere Kraft erforderlich als während des Haltevorgangs, in dem es ausreicht, die Antriebsspule so zu bestromen, dass die Schaltkontakte geschlossen gehalten werden. In der Regel wird daher während des Anzugvorgangs die Laststrecke des FET 20 durch ein von einer Ansteuerelektronik 30 des Antriebs erzeugtes Puls-Weiten-Moduliertes (PWM)-Steuersignal 22 derart angesteuert, dass der von der Gleichspannungsquelle 28 durch die Antriebsspule 14 fließende Strom i so groß ist, dass von der Antriebsspule 14 ein ausreichend starkes magnetisches Feld zum Überwinden der zum Schließen der Schaltkontakte erforderlichen Kraft aufgebaut wird. Sobald die Schaltkontakte geschlossen sind, kann der Strom i soweit reduziert werden, dass ein zum Halten der Schaltkontakte im geschlossenen Zustand ausreichend starkes Magnetfeld von der Antriebsspule 14 erzeugt wird. Die Steuerung des Stromes i kann beispielsweise durch eine Modulation der Pulsweite des PWM-Steuersignals 22 erfolgen. Es ist auch möglich, den FET 20 während des Anzugvorgangs vollständig durchzuschalten, und erst während des Haltevorgangs auf eine PWM-Ansteuerung des FET 20 umzuschalten.

Nachfolgend wird nun das Messprinzip der vorliegenden Erfindung erläutert: der während des Anzug- oder Haltevorgangs durch die Antriebsspule 14 fließende Strom i fließt auch durch die in Reihe geschaltete Primärseite 12 des Übertragers 10. Im Übertrager 10 wird dadurch ein magnetischer Fluss generiert:

$$\emptyset_{\ddot{U}bertrager} = \frac{L_1 \cdot i}{N_1}$$

Dadurch wird auf die Sekundärseite 16, d.h. auf die sekundärseitige Spule mit der Induktivität $L_2$ und der Windungszahl $N_2$ des Übertragers 10 eine Spannung $U_{L_2}$ übertragen:

$$U_{L2} = N_2 \frac{d\emptyset_{\ddot{U}bertrager}}{dt}$$

$$U_{L2} = L_1 \cdot \frac{N_2}{N_1} \cdot \frac{di}{dt}$$

Die Spannung $U_{L2}$ enthält nun Informationen zum Anzug- bzw. Haltestrom i, zum Anker-Kern-Stoß und zur Induktivität $L_{Antrieb}$ der Antriebsspule 14 und damit einer Bewegung des elektromagnetischen Antriebs, welche die Induktivität $L_{Antrieb}$ der Antriebsspule 14 beeinflusst. Eine digitale elektronische Messvorrichtung 18 ist nun vorgesehen, um die auf die Sekundärseite übertragene Spannung $U_{L2}$ zu messen und mindestens eine der vorgenannten Messgröße des elektromagnetischen Antriebs abhängig von der gemessenen Spannung $U_{L2}$ und bekannten Werten des Übertragers und / oder des Antriebs gemäß mindestens einer Ermittlungs- und Berechnungsfunktion zu ermitteln.

Hierzu kann die digitale elektronische Messvorrichtung eine oder mehrere der folgenden Ermittlungs- und Berechnungsfunktionen implementieren:

Aus den bekannten und konstanten Kennwerten $N_1$, $N_2$, $L_1$ des Übertragers 10 und der gemessenen Spannung $U_{L2}$ kann die digitale elektronische Messvorrichtung 18 den Anzug-bzw. Haltestrom i durch (numerische) Integration gemäß der folgenden Gleichung ermitteln:

$$i = \frac{N_1}{L_1 \cdot N_2} \cdot \int U_{L2} \cdot dt$$

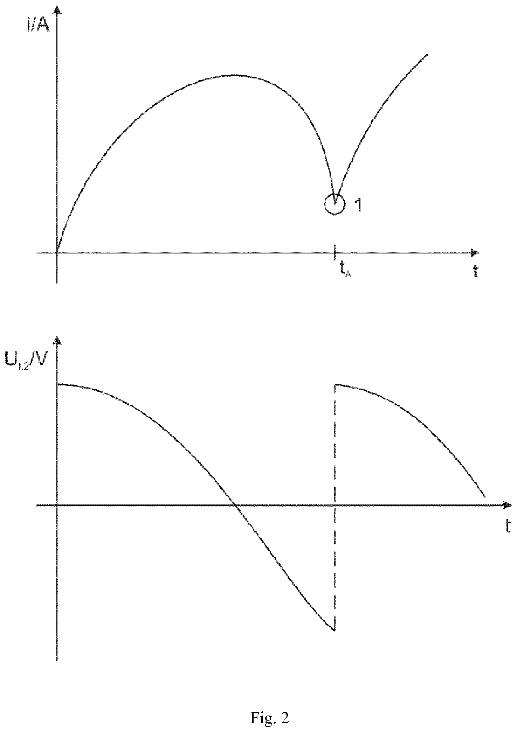

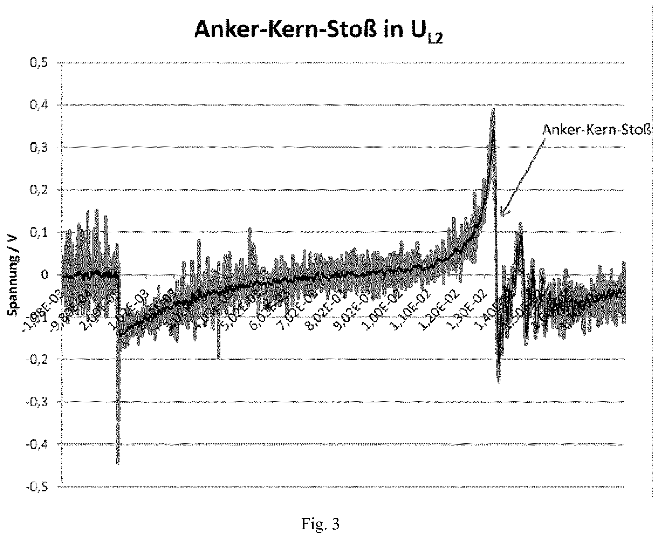

Weiterhin kann die digitale elektronische Messvorrichtung 18 den Anker-Kern-Stoß ermitteln. Der Anker-Kern-Stoß tritt auf, wenn der Anker und der Kern des elektromagnetischen Antriebs des Schaltgeräts am Ende des Anzugvorgangs auf einander treffen und sich nicht mehr weiter bewegen können, typischerweise nachdem die Schaltkontakte vollständig geschlossen sind. In Fig. 2 sind typische Verläufe der Spannung $U_{L2}$ während eines Anzugvorgangs und des Anzugstroms i über die Zeit gezeigt. Der im obigen Diagramm dargestellte Verlauf des Anzugstroms i zeigt, dass der Strom bis zu einem Scheitelpunkt zunächst ansteigt, um dann wieder abzufallen auf einen relativ niedrigen Wert zum Zeitpunkt $t_A$, wenn ein Anker-Kern-Stoß auftritt. Zu diesem Zeitpunkt macht auch die Spannung $U_{L2}$ einen Sprung, wie anhand des unten gezeigten Spannungsverlaufs erkennbar ist. Die Messvorrichtung 18 kann daher einen solchen Sprung der Spannung $U_{L2}$ und damit einen Anker-Kern-Stoß detektieren. Fig. 3 zeigt ein Diagramm mit dem Verlauf der mit der Vorrichtung erfassten Spannung $U_{L2}$, aus dem der Anker-Kern-Stoß an dem Spannungssprung etwa zum Zeitpunkt bei bei 1,4E-02 Sekunden hervorgeht.

Die elektronische Messvorrichtung 18 kann auch wie folgt die Induktivität $L_{Antrieb}$ der Antriebsspule 14 und damit deren Bewegung ermitteln: in dem PWM-Steuersignal 22 zum Ansteuern des Antriebs sind Frequenzanteile enthalten, die wie folgt ausgewertet werden können. Das PWM-Steuersignal 22 weist eine vorgegebene Periodendauer T unabhängig von der Spannung $U_{PWM}$ (siehe Fig. 1) auf. Die vorgegebene Periodendauer T ist die Summe aus einer Zeitdauer $t_{on}$, während der das PWM-Ansteuersignal 22 einen ersten Wert zum Durchschalten des FET 20 aufweist, und der Zeitdauer $t_{off}$, während der das PWM-Ansteuersignal 22 einen zweiten Wert zum Sperren des FET 20 aufweist. Der reziproke Wert von T ist die PWM-Frequenz $f_{PWM}$ = 1/T. Diese Grundfrequenz findet sich auch in den beiden Spannungen $U_{L1}$ und $U_{L2}$ am Übertrager 10 wieder. Die Amplitude dieser Frequenz hängt vom Luftspalt im Antrieb und somit von der Induktivität $L_{Antrieb}$ der Antriebsspule 14 ab. Daraus ergibt sich gemäß der folgenden Gleichung folgender Zusammenhang:

$$\frac{U_{L1;fpwm}}{U_{PWM;fpwm}} = \frac{j\omega L_1}{j\omega L_1 + j\omega L_{Antrieb}} = \frac{L_1}{L_1 + L_{Antrieb}}$$

Die Spannung $U_{L1}$ wird mit einem bekannten und konstanten Faktor $\beta$ auf die Sekundärseite des Übertragers 10 in die Spannung $U_{L2}$ übertragen.

Die digitale elektronische Messvorrichtung 18 kann eine FFT (Fast Fourier Transformation) mit den Spannungen $U_{L2}$ und $U_{PWM}$ durchführen, um die Spannungen in ihre Frequenzanteile zu zerlegen, und damit $L_{Antrieb}$ gemäß der folgenden Gleichung bestimmen:

$$L_{Antrieb} = (\frac{U_{PWM}}{U_{L2} \cdot \beta} - 1) \cdot L_1$$

Die Induktivität $L_1$ der Primärseite des Übertragers 10 ist bekannt und konstant, während sich die Induktivität $L_{Antrieb}$ der Antriebsspule 14 während des Anzugvorgangs ändert und mit der obigen Gleichung von der elektronischen Messvorrichtung zu jedem Zeitpunkt des Anzugvorgangs berechnet werden kann.

Die digitale elektronische Messvorrichtung 18 kann den Luftspalt im Antrieb aus der berechneten Induktivität $L_{Antrieb}$ der Antriebsspule 14 in Kenntnis einer Kennlinie s($L_{Antrieb}$) des Antriebs, die beispielsweise in einem Speicher der Messvorrichtung 18 abgelegt sein kann und den Bezug zwischen Luftspalt und Induktivität angibt, bestimmen.

Aus der berechneten Induktivität $L_{Antrieb}$ der Antriebsspule 14 und mit dem bekannten Strom i durch die Antriebsspule 14 kann die digitale elektronische Messvorrichtung 18 auch den magnetischen Verkettungsfluss im Antrieb gemäß folgender Gleichung berechnen:

$$\Psi_{Antrieb} = L_{Antrieb} \cdot i$$

Alle von der digitalen elektronischen Messvorrichtung 18 ermittelten Parameter können von dieser insbesondere an die Ansteuerelektronik 30 ausgegeben werden.

Die digitale elektronische Messvorrichtung 18 kann durch einen Prozessor, insbesondere eine Mikroprozessor oder Mikrokontroller, implementiert werden, der eine Firmware des Schaltgeräts ausführt, welche die oben beschriebenen Ermittlungs- und Berechnungsfunktionen implementiert. Die Spannung $U_{L2}$ kann hierzu von der digitalen elektronischen Messvorrichtung 18 digitalisiert werden, beispielsweise über einen integrierten Analog-Digital-Wandler. Es ist selbstverständlich auch möglich, die elektronische Messvorrichtung in Hardware zu implementieren, beispielsweise durch einen ASIC (Application Sepcific Integrated Circuit) oder ein (F)PGA ((Field) Programable Gate Array). Die von der digitalen elektronischen Messvorrichtung 18 berechenbaren Parameter können für verschiedene Anwendungen in einem Schaltgerät verwendet werden, wie es im Folgenden erläutert wird.

Die Detektion eines Anker-Kern-Stoßes durch die elektronische Messvorrichtung 18 kann als Signal der Ansteuerelektronik 30 zum Steuern des elektromagnetischen Antriebs, insbesondere mit einer Anzug- und einer Haltespule, zugeführt werden. Die Ansteuerelektronik 30 kann beim Empfang des Signals eine Bestromung des Spulensystems von Anziehen auf Halten umschalten, insbesondere eine Bestromung der Anzugspule abschalten und eine Bestromung der Haltespule einschalten. Durch diese Steuerung kann der Umschaltvorgang von Anziehen auf Halten besser an den elektromagnetischen Antrieb, insbesondere an ein im Laufe der Betriebszeit verändertes Verhalten angepasst werden. Außerdem kann Energie beim Anziehen eingespart werden. Zudem werden Leistungsbauelemente im Schaltgerät hierdurch weniger stark belastet, als bei beispielsweise einer zeitgesteuerten Umschaltung, die nicht an ein geändertes Verhalten des Antriebs angepasst wird.

Regelaufgaben können ebenfalls auf Basis der von der elektronischen Messvorrichtung 18 berechenbaren Parameter implementiert werden. Hierzu kann der von der Messvorrichtung 18 berechnete magnetischen Verkettungsfluss Antrieb der Ansteuerelektronik 30 zum Regeln des elektromagnetischen Antriebs zugeführt werden, wie es auch in der eingangs genannten deutschen Patentanmeldung DE 10 2012 106 922.0 erläutert ist. Eine Regelung kann auch mit der Bewegung des elektromagnetischen Antriebs als Regelgröße implementiert werden. Beispielsweise kann über die Induktivität $L_{Antrieb}$ der Spule des elektromagnetischen Antriebs und/oder des Luftspalts im elektromagnetischen Antrieb, die von der Messvorrichtung 18 ermittelt werden, die Bewegung des elektromagnetischen Antriebs genau eingestellt und auf eine vorgegebene Bewegung geregelt werden. Durch eine genaue Kontrolle der Bewegung kann der elektromagnetische Antrieb genau eingestellt werden, was auch Vorteile in der Auslegung der Hauptkontakte eines Schaltgeräts bietet. Die benötigte Kraft zum Bewegen der Kontakte kann hierdurch genau und automatisch auf die Einbaulage des Schaltgeräts, beispielsweise eines Schützes, eingestellt werden. Da hierbei auch Temperaturbeeinflussungen ausgeregelt werden, kann eine Temperaturkompensation entfallen.

Im Folgenden werden nun einige Anwendungsmöglichkeiten der vorliegenden Erfindung genauer beschrieben.

Lagenerkennung eines Schützes

Schützantriebe weisen typischerweise aus zwei metallischen Komponenten auf: der Anker und der Kern. Auf dem Anker ist in der Regel die Antriebsspule montiert. Der Anker ist mit einer Kontaktbrücke verbunden. Durch Abdruckfedern wird, im nichterregten Zustand der Antriebsspule, zwischen Anker und Kern ein Luftspalt erzeugt. Fließt durch die Spule ein ausreichend großer Strom, wird ein Magnetfeld ausgebildet, das derart bemessen ist, dass der Kern auf den Anker gezogen wird. Durch das Magnetfeld muss also eine Kraft $F_{mag}$ erzeugt werden, die ausreicht, um den Kern und die Brücke (also deren Masse) zu beschleunigen und die Kräfte der Abdruckfedern zu überwinden. Abhängig von der Einbaulage eines Schützes kann auch die Erdanziehungskraft $F_g$ den Schützantrieb beeinflussen. Ist die Montagelage so gewählt, dass die Bewegung des Kerns in Richtung der Erdanziehung gerichtet ist wirkt diese voll auf den Kern und Brücke und beschleunigt diese zusätzlich. Wird das Schütz auf einer zur Wirkrichtung der Erdanziehung orthogonalen Achsen montiert, wirkt die Erdanziehungskraft nicht auf den Schützantrieb und beschleunigt diesen auch nicht. Die auf den Schützantrieb wirkende gesamte Kraft $F_{Antrieb}$ setzt sich also aus der Kraft $F_{mag}$ und der Komponente der Erdanziehungskraft $F_g \cos(\varphi_{Montage})$ zusammen, die auf den Schützantrieb wirkt, wobei $\varphi_{Montage}$ den Winkel zwischen Bewegungsrichtung des Schützantriebs und der Richtung der Erdanziehung bezeichnet:

$$F_{Antrieb} = F_{mag} + F_g \cdot \cos(\varphi_{Montage})$$

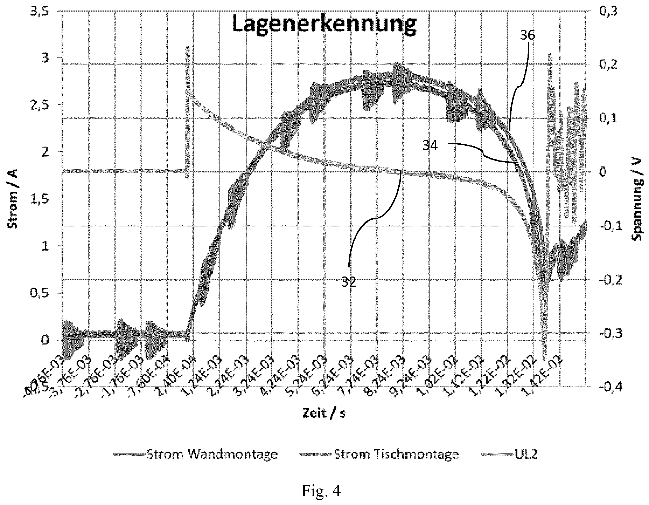

Wird die Masse immer mit der gleichen Kraft zu anfangs beschleunigt, hängt die Bewegung der Masse von der Einbaulage ab. Automatisch stellt sich ein geringerer Strom im Wendepunkt der Stromkurve ein. In Fig. 4 sind die Verläufe 34, 36 von Antriebsströmen bei zwei unterschiedlichen Einbaulagen eines Schützes gezeigt. Weiterhin ist der simulierte Verlauf 32 der gemessenen Spannung $U_{L2}$ gezeigt. Aus ihr kann nicht nur der Strom im Antrieb berechnet werden, sondern auch der Zeitpunkt des Wendepunktes bestimmt werden. Da $U_{L2}$ die Ableitung des Stromes ist, wird diese Spannung im Wendepunkt zu Null. Dies ist der Zeitpunkt, an dem der ermittelte Strom bewertet wird und von der Steuerung entschieden werden muss, ob die Kraft angepasst werden muss.

Die beiden Stromkurven 34, 36 in Fig. 4 wurden bei unterschiedlichen Einbaulagen eines Schützes aufgenommen. Die Spannung UL2 - Verlauf 32 - gehört zur Stromkurve 36 und repräsentiert die sogenannte Wandmontage. Zum Vergleich ist die Stromkurve 34 in einer sog. Tischmontage aufgenommen worden. Die Effekte sind hier bereits messbar. Bedingt durch die geringe Masse im Antrieb ist die Auswirkung der Erdanziehung nicht so stark. Werden Antriebe mit größeren Massen verwendet sind die Effekte deutlich ausgeprägter.

Überwachung der Mechanik

Auf das Schaltverhalten eines Schützes haben viele Faktoren Einfluss. So sind z.B. die Stärken der Abdruckfedern im Zusammenspiel mit den eingestellten Antriebskräften maßgeblich für die Einschaltzeit, also die Zeit, die das Schütz benötigt, um nach Anlegen eines Schaltbefehls die Kontakte zu schließen. Ändert sich die Schaltzeit kann das ein Indiz für einen Defekt sein. Bricht z.B. eine Feder fällt deren Gegenkraft weg. Das Schütz schaltet schneller auf Grund der gleichbleibenden magnetischen Kräfte. Diese nun zu hohen Kräfte können für den Rest der Mechanik auf mittlere Zeitsicht zu groß sein und diese beschädigen.

Das Überwachen der Schaltzeit kann mit der vorliegenden Erfindung durch Detektion des Anker-Kern-Stoßes geschehen. Wird dieser zu früh oder zu spät erkannt weiß die Steuerung des Schützes, dass ein Fehler in der Kräfteeinstellung vorliegt und das Schütz repariert oder ausgetauscht werden muss. Dies kann über geeignete Schnittstellen weitergegeben werden.

Bestimmung der Temperatur der Antriebsspule

Sind die Antriebsspule und die Steuerelektronik eines Schützes weit voneinander entfernt, kann es Unterschiede in der jeweiligen Erwärmung geben. Dadurch kann es vorkommen, dass ein Temperatursensor auf oder nahe der Steuerelektronik nicht die richtige Temperatur misst, um den temperaturabhängigen Widerstand der Antriebsspule ausreichend genau zu kompensieren.

Eine Möglichkeit an diese Informationen zu gelangen ist, den Antrieb mit Halteenergie zu bestromen. Dadurch setzt sich der Antrieb des Schützes noch nicht in Bewegung. Die beaufschlagte Spannung ist bekannt und der sich einstellende Strom kann gemessen werden. Dadurch kann der Widerstand des Antriebes ermittelt werden und für eine Temperaturkompensation eingesetzt werden.

Die vorliegende Erfindung basiert auf der Übertragung von Informationen über den elektromagnetischen Antrieb eines Schaltgeräts durch eine induktive Übertragungsstrecke und ermöglicht Rückschlüsse aus dem Antrieb. Sie ermöglicht die Regelung von Geschwindigkeiten beim Bewegen des elektromagnetischen Antriebs eines Schaltgerät, welche die Lebensdauer des Schaltgeräts wesentlich beeinflussen. Die benötigte Kraft zum Bewegen des Antriebs kann durch die Erfindung genau auf die Bedürfnisse des Antriebs eingestellt werden, wobei die Einbaulage eines Schaltgeräts, insbesondere eines Schützes, die Eingangsspannung und Temperatur des Antriebs keine Rolle mehr spielen. Die Verlustleistung bei einem Anzugvorgang im Antrieb kann durch die Erfindung ebenfalls reduziert werden. Leistungsbauteile können entlastet werden. Durch eine lagenunabhängige Regelung gemäß der Erfindung kann die Anzugleistung verringert werden. Nicht zuletzt können der Montageaufwand im Vergleich zu Zweispulen-Antriebssystemen von Schaltgeräten und damit die Fehlerquellen bei der Produktion von Schaltgeräten verringert werden. Bezugszeichen

| | |
|---|---|
| 10 | Übertrager |
| 12 | Primärseite des Übertragers 10 |
| 14 | Antriebsspule |
| 16 | Sekundärseite des Übertragers 10 |
| 18 | digitale elektronische Messvorrichtung |
| 20 | Feldeffekttransistor (FET) |
| 22 | Puls-Weiten-Moduliertes (PWM)-Steuersignal |
| 24 | Freilauf-Diode |
| 26 | Kondensator |
| 28 | Gleichspannungsquelle |
| 30 | Ansteuerelektronik für den elektromagnetischen Antrieb |
| 32 | Verlauf der gemessenen Spannung $U_{L2}$ |
| 34 | Verlauf des Antriebsstromes bei einer Tischmontage eines Schützes |
| 36 | Verlauf des Antriebsstromes bei einer Wandmontage eines Schützes |

**Patentansprüche**

1. Schaltgerät, insbesondere Schütz, mit
einem elektromagnetischen Schaltantrieb, der ein Antriebsspulensystem, insbesondere mit einer Anzugspule und einer Haltespule, aufweist, und
einer Steuer- oder Regelvorrichtung zum Steuern der Bestromung des Antriebsspulensystems oder zum Regeln des elektromagnetischen Antriebs,
wobei die Steuer- oder Regelvorrichtung eine Vorrichtung zur Messgrössenerfassung im elektromagnetischen Antrieb des Schaltgeräts aufweist mit

- einem induktiven Übertrager (10), dessen Primärseite (12) in Reihe mit einer Spule (14) des elektromagnetischen Antriebs geschaltet ist,
wobei das Schaltgerät **dadurch gekennzeichnet ist, dass** die Vorrichtung zur Messgrößenerfassung weiter
- eine mit der Sekundärseite (16) des Übertragers verbundene digitale elektronische Messvorrichtung (18) zum Messen einer auf die Sekundärseite übertragenen Spannung $U_{L2}$ und zum Ermitteln von mindestens einer Messgröße des elektromagnetischen Antriebs abhängig von der gemessenen Spannung $U_{L2}$ und bekannten Werten des Übertragers und / oder des Antriebs gemäß mindestens einer Ermittlungs- und Berechnungsfunktion aufweist.

2. Schaltgerät nach Anspruch 1, **dadurch gekennzeichnet, dass** die Messvorrichtung (18) konfiguriert ist, einen durch die Spule (14) des elektromagnetischen Antriebs fließenden Strom i gemäß der Gleichung

$$i = \frac{N_1}{L_1 \cdot N_2} \cdot \int U_{L2} \cdot dt$$

zu ermitteln, wobei $L_1$ die Induktivität und $N_1$ die Windungszahl der Primärseite und $L_2$ die Induktivität und $N_2$ die Windungszahl der Sekundärseite des Übertragers (10) bezeichnen.

3. Schaltgerät nach Anspruch 2, **dadurch gekennzeichnet, dass** die Messvorrichtung (18) konfiguriert ist, den Verlauf des Stromes i zu ermitteln und abhängig vom ermittelten Verlauf eine Einbaulage des Schaltgeräts zu ermitteln.

4. Schaltgerät nach Anspruch 2 oder 3, **dadurch gekennzeichnet, dass** die Messvorrichtung (18) konfiguriert ist, den Strom i zu ermitteln, wenn der elektromagnetische Antrieb in einem Haltezustand betrieben wird, in dem sich der Antrieb nicht in Bewegung befindet, und abhängig vom ermittelten Strom die Temperatur des Spule (14) des elektromagnetischen Antriebs zu ermitteln.

5. Schaltgerät nach Anspruch 1, 2, 3 oder 4, **dadurch gekennzeichnet, dass** die Messvorrichtung (18) konfiguriert ist, einen Anker-Kern-Stoß durch Auswerten des Verlaufs der gemessenen Spannung $U_{L2}$ zu ermitteln, indem ein Anker-Kern-Stoß detektiert wird, wenn die Spannung $U_{L2}$ einen Sprung vom negativen in den positiven Bereich macht.

6. Schaltgerät nach Anspruch 5, **dadurch gekennzeichnet, dass** die Messvorrichtung (18) konfiguriert ist, den Zeitpunkt des Auftretens eines Anker-Kern-Stosses zu ermitteln und abhängig von dem ermittelten Zeitpunkt einen Zustand der Mechanik des elektromagnetischen Antriebs zu ermitteln.

7. Schaltgerät nach Anspruch 6, **dadurch gekennzeichnet, dass** die Messvorrichtung (18) konfiguriert ist, eine Zeitmessfunktion zu implementieren, um den Zeitpunkt eines Anker-Kern-Stosses nach Bestromung des elektromagnetischen Antriebs zu ermitteln und zu überprüfen, ob der ermittelte Zeitpunkt in einem vorgegebenen Bereich liegt, der einen vorgegebenen, insbesondere guten Zustand der Antriebsmechanik umfasst.

8. Schaltgerät nach einem der vorhergehenden Ansprüche, **dadurch gekennzeichnet, dass** die Messvorrichtung (18) konfiguriert ist, die Induktivität $L_{Antrieb}$ der Spule (14) des elektromagnetischen Antriebs gemäß der Gleichung

$$L_{Antrieb} = \left(\frac{U_{PWM}}{U_{L2} \cdot \beta} - 1\right) \cdot L_1$$

zu ermitteln, wobei $L_1$ die Induktivität der Primärseite des Übertragers (10) und $\beta$ den Faktor der Übertragung der Spannung $U_{L1}$ an der Primärseite des Übertragers (10) auf die Spannung $U_{L2}$ bezeichnen, und wobei $U_{PWM}$ die über der Reihenschaltung der Spule (14) des elektromagnetischen Antriebs und der Primärseite (12) des Übertragers (10) abfallende und von der Messvorrichtung (18) ermittelte Spannung bezeichnet.

9. Schaltgerät nach Anspruch 8, **dadurch gekennzeichnet, dass** die Messvorrichtung (18) ferner konfiguriert ist, anhand einer Kennlinie $s(L_{Antrieb})$ der Induktivität der Spule (14) des elektromagnetischen Antriebs, die den Bezug zwischen Luftspalt und Induktivität angibt, einen Luftspalt im elektromagnetischen Antrieb zu bestimmen.

10. Schaltgerät nach Anspruch 8 oder 9, **dadurch gekennzeichnet, dass** die Messvorrichtung (18) konfiguriert ist, den magnetischen Verkettungsfluss Antrieb im elektromagnetischen Antrieb abhängig von der ermittelten Induktivität $L_{Antrieb}$ der Spule (14) des elektromagnetischen Antriebs und dem ermittelten durch die Spule (14) des elektromagnetischen Antriebs fließenden Anzugstrom i gemäß der Gleichung

$$\Psi_{Antrieb} = L_{Antrieb} \cdot i$$

zu ermitteln.

**11.** Schaltgerät nach einem der Ansprüche 5 bis 10, wobei die Steuer- oder Regelvorrichtung eine Ansteuerelektronik (30) zum Steuern des elektromagnetischen Antriebs aufweist, wobei die Ansteuerelektronik (30) derart konfiguriert ist, dass sie bei Detektion eines Anker-Kern-Stoßes eine Bestromung des Antriebsspulensystems von einem Anzug- auf einen Haltebetrieb umschaltet, insbesondere die Bestromung der Anzugspule abschaltet und eine Bestromung der Haltespule einschaltet.

**12.** Schaltgerät nach einem der Ansprüche 8 bis 10, wobei die Steuer-oder Regelvorrichtung eine Ansteuerelektronik (30) zum Steuern des elektromagnetischen Antriebs aufweist, wobei die Ansteuerelektronik (30) derart konfiguriert ist, dass sie die Bestromung einer Spule (14) des elektromagnetischen Antriebs abhängig von der ermittelten Induktivität $L_{Antrieb}$, vom ermittelten Luftspalt und/oder vom ermittelten magnetischen Verkettungsfluss $\Psi_{Antrieb}$ regelt.

**Claims**

**1.** Switching device, in particular a contactor, comprising
an electromagnetic switching drive which has a drive coil system, in particular having a pull-in coil and a holding coil, and
an open-loop or closed-loop control device for controlling the energization of the drive coil system in an open-loop manner or for controlling the electromagnetic drive in a closed-loop manner, the open-loop or closed-loop control device having a device for detecting measured variables in the electromagnetic drive of the switching device, which device has

- an inductive transformer (10), the primary side (12) of which is connected in series with a coil (14) of the electromagnetic drive,
the switching device being **characterized in that** the device for detecting measured variables further has
- a digital electronic measuring device (18) connected to the secondary side (16) of the transformer for measuring a voltage $U_{L2}$ transferred to the secondary side and for determining at least one measured variable of the electromagnetic drive as a function of the measured voltage $U_{L2}$ and known values of the transformer and/or of the drive according to at least one determination and calculation function.

**2.** Switching device according to claim 1, **characterized in that** the measuring device (18) is configured to determine a current i flowing through the coil (14) of the electromagnetic drive according to the equation

$$i = \frac{N_1}{L_1 \cdot N_2} \cdot \int U_{L2} \cdot dt$$

where $L_1$ denotes the inductance and $N_1$ denotes the number of turns on the primary side of the transformer (10) and $L_2$ denotes the inductance and $N_2$ denotes the number of turns on the secondary side of the transformer.

**3.** Switching device according to claim 2, **characterized in that** the measuring device (18) is configured to determine the curve of the current i and to determine an installation position of the switching device as a function of the determined curve.

**4.** Switching device according to either claim 2 or 3, **characterized in that** the measuring device (18) is configured to determine the current i when the electromagnetic drive is operated in a holding state in which the drive is not in motion, and to determine the temperature of the coil (14) of the electromagnetic drive as a function of the determined current.

**5.** Switching device according to claims 1, 2, 3 or 4, **characterized in that** the measuring device (18) is configured to determine an armature-core impact by evaluating the curve of the measured voltage $U_{L2}$ by an armature-core impact being detected when the voltage $U_{L2}$ makes a jump from the negative range to the positive range.

6. Switching device according to claim 5, **characterized in that** the measuring device (18) is configured to determine the point in time of the occurrence of an armature-core impact and to determine a state of the mechanics of the electromagnetic drive as a function of the point in time determined.

7. Switching device according to claim 6, **characterized in that** the measuring device (18) is configured to implement a time measurement function in order to determine the point in time of an armature-core impact after energization of the electromagnetic drive and to check whether the determined point in time lies in a predetermined range which comprises a predetermined, in particular good, state of the drive mechanism.

8. Switching device according to any of the preceding claims, **characterized in that** the measuring device (18) is configured to determine the inductance $L_{Antrieb}$ of the coil (14) of the electromagnetic drive according to the equation

$$ L_{Antrieb} = \left( \frac{U_{PWM}}{U_{L2} \cdot \beta} - 1 \right) \cdot L_1 $$

where $L_1$ denotes the inductance of the primary side of the transformer (10) and $\beta$ denotes the factor of the transfer of the voltage $U_{L1}$ at the primary side of the transformer (10) to the voltage $U_{L2}$, and where $U_{PWM}$ denotes the voltage which drops across the series connection of the coil (14) of the electromagnetic drive and the primary side (12) of the transformer (10) and is determined by the measuring device (18).

9. Switching device according to claim 8, **characterized in that** the measuring device (18) is further configured to determine an air gap in the electromagnetic drive on the basis of a characteristic curve $s(L_{Antrieb})$ of the inductance of the coil (14) of the electromagnetic drive, which characteristic curve indicates the relationship between the air gap and the inductance.

10. Switching device according to either claim 8 or claim 9, **characterized in that** the measuring device (18) is configured to determine the magnetic flux linkage $\Psi_{Antrieb}$ in the electromagnetic drive as a function of the determined inductance $L_{Antrieb}$ of the coil (14) of the electromagnetic drive and the determined pull-in current i flowing through the coil (14) of the electromagnetic drive according to the equation

$$ \Psi_{Antrieb} = L_{Antrieb} \cdot i $$

.

11. Switching device according to any of claims 5 to 10, wherein the open-loop or closed-loop control device has control electronics (30) for controlling the electromagnetic drive, wherein the control electronics (30) are configured such that, when an armature-core impact is detected, said electronics switch an energization of the drive coil system from a pull-in mode to a holding mode, in particular switch off the energization of the pull-in coil and switch on an energization of the holding coil.

12. Switching device according to any of claims 8 to 10, wherein the open-loop or closed-loop control device has control electronics (30) for controlling the electromagnetic drive, wherein the control electronics (30) are configured such that they control the energization of a coil (14) of the electromagnetic drive in a closed-loop manner, as a function of the determined inductance $L_{Antrieb}$, the determined air gap and/or the determined magnetic flux linkage $\Psi_{Antrieb}$.

**Revendications**

1. Appareil de commutation, notamment disjoncteur, comportant
   un entraînement électromagnétique de commutation qui présente un système à bobines d'entraînement, comportant en particulier une bobine d'appel et une bobine de maintien, et un dispositif de commande ou de régulation permettant de commander l'alimentation en courant du système à bobines d'entraînement ou de réguler l'entraînement électromagnétique, dans lequel le dispositif de commande ou de régulation présente un dispositif de mesure de paramètres dans l'entraînement électromagnétique de l'appareil de commutation avec

   - un transformateur inductif (10) dont le côté primaire (12) est connecté en série avec une bobine (14) de l'entraînement électromagnétique,

dans lequel l'appareil de commutation est **caractérisé en ce que** le dispositif de mesure de paramètres présente en outre

- un dispositif de mesure électronique numérique (18) connecté au côté secondaire (16) du transformateur destiné à mesurer une tension $U_{L2}$ transmise au côté secondaire et à déterminer, selon au moins une fonction de détermination et de calcul, au moins un paramètre de l'entraînement électromagnétique en fonction de la tension $U_{L2}$ mesurée et des valeurs connues du transformateur et/ou de l'entraînement.

2. Appareil de commutation selon la revendication 1, **caractérisé en ce que** le dispositif de mesure (18) est configuré pour déterminer un courant i circulant à travers la bobine (14) de l'entraînement électromagnétique, selon l'équation

$$i = \frac{N_1}{L_1 \cdot N_2} \cdot \int U_{L2} \cdot dt$$

dans laquelle $L_1$ représente l'inductance et $N_1$ représente le nombre de spires du côté primaire, et $L_2$ représente l'inductance et $N_2$ représente le nombre de spires du côté secondaire du transformateur (10).

3. Appareil de commutation selon la revendication 2, **caractérisé en ce que** le dispositif de mesure (18) est configuré pour déterminer la variation du courant i, et pour déterminer une position de montage de l'appareil de commutation en fonction de la variation déterminée.

4. Appareil de commutation selon la revendication 2 ou 3, **caractérisé en ce que** le dispositif de mesure (18) est configuré pour déterminer le courant i lorsque l'entraînement électromagnétique est actionné dans un état de verrouillage dans lequel l'entraînement n'est pas en mouvement, et pour déterminer, en fonction du courant déterminé, la température de la bobine (14) de l'entraînement électromagnétique.

5. Appareil de commutation selon la revendication 1, 2, 3 ou 4, **caractérisé en ce que** le dispositif de mesure (18) est configuré pour déterminer un contact noyau-armature en évaluant la variation de la tension $U_{L2}$ mesurée par détection d'un contact noyau-armature lorsque la tension $U_{L2}$ passe du négatif au positif.

6. Appareil de commutation selon la revendication 5, **caractérisé en ce que** le dispositif de mesure (18) est configuré pour déterminer le moment de la survenue d'un contact noyau-armature, et pour déterminer, en fonction du moment déterminé, un état du système mécanique de l'entraînement électromagnétique.

7. Appareil de commutation selon la revendication 6, **caractérisé en ce que** le dispositif de mesure (18) est configuré pour exécuter une fonction de mesure du temps afin de déterminer le moment d'un contact noyau-armature après l'alimentation en courant de l'entraînement électromagnétique, et de vérifier si le moment déterminé est situé dans une plage prédéterminée qui comprend un état prédéterminé particulièrement bon du mécanisme d'entraînement.

8. Appareil de commutation selon l'une des revendications précédentes, **caractérisé en ce que** le dispositif de mesure (18) est configuré pour déterminer l'inductance $L_{Antrieb}$ de la bobine (14) de l'entraînement électromagnétique, selon l'équation

$$L_{Antrieb} = \left( \frac{U_{PWM}}{U_{L2} \cdot \beta} - 1 \right) \cdot L_1$$

dans laquelle $L_1$ représente l'inductance du côté primaire du transformateur (10) et $\beta$ représente le facteur de transmission de la tension $U_{L1}$ au niveau du côté primaire du transformateur (10) vers la tension $U_{L2}$, et dans laquelle $U_{PWM}$ représente la connexion en série de la bobine (14) de l'entraînement électromagnétique et le côté primaire (12) du transformateur (10) représente la tension qui chute et est déterminée par le dispositif de mesure (18).

9. Appareil de commutation selon la revendication 8, **caractérisé en ce que** le dispositif de mesure (18) est en outre configuré pour déterminer, sur la base d'une courbe caractéristique s ($L_{Antrieb}$) de l'inductance de la bobine (14) de l'entraînement électromagnétique, laquelle courbe indique la relation entre entrefer et inductance, un entrefer dans l'entraînement électromagnétique.

**10.** Appareil de commutation selon la revendication 8 ou 9, **caractérisé en ce que** le dispositif de mesure (18) est configuré pour déterminer le flux magnétique d'interconnexion $\Psi_{Antrieb}$ dans l'entraînement électromagnétique en fonction de l'inductance $L_{Antrieb}$ déterminée de la bobine (14) de l'entraînement électromagnétique et du courant d'appel i déterminé circulant dans la bobine (14) de l'entraînement électromagnétique, selon l'équation

$$\Psi_{Antrieb} = L_{Antrieb} \cdot i$$

.

**11.** Appareil de commutation selon l'une des revendications 5 à 10, dans lequel le dispositif de commande ou de régulation présente un système électronique de commande (30) pour la commande de l'entraînement électromagnétique, dans lequel le système électronique de commande (30) est configuré de façon à faire passer l'alimentation en courant du système à bobines d'entraînement d'un régime d'appel à un régime de maintien lorsqu'un contact noyau-armature est détecté, coupe en particulier l'alimentation en courant de la bobine d'appel et enclenche une alimentation en courant de la bobine de maintien.

**12.** Appareil de commutation selon l'une des revendications 8 à 10, dans lequel le dispositif de commande ou de régulation présente un système électronique de commande (30) pour la commande de l'entraînement électromagnétique, dans lequel l'électronique de commande (30) est configurée de façon à réguler l'alimentation en courant d'une bobine (14) de l'entraînement électromagnétique en fonction de l'inductance $L_{Antrieb}$ déterminée, de l'entrefer déterminé et/ou du flux magnétique d'interconnexion $\Psi_{Antrieb}$ déterminé.

Fig. 1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102012106922
- EP 0549911 A1
- DE 102007063479
- FR 2803956
- US 333777 A